Europäisches Patentamt

European Patent Office

Office européen des brevets

(11) Publication number: **0 166 004**
**B1**

# EUROPEAN PATENT SPECIFICATION

(45) Date of publication of patent specification: **30.11.88**

(21) Application number: **84106180.7**

(22) Date of filing: **30.05.84**

(51) Int. Cl.⁴: **H 01 J 37/317,**
**H 01 J 37/304, G 03 F 7/20**

---

(54) Proximity effect correction method for E-beam lithography.

---

(43) Date of publication of application:
**02.01.86 Bulletin 86/01**

(45) Publication of the grant of the patent:
**30.11.88 Bulletin 88/48**

(84) Designated Contracting States:
**DE FR GB**

(56) References cited:
**EP-A-0 073 658**
**EP-A-0 080 526**
**DE-A-2 755 399**

(73) Proprietor: **International Business Machines Corporation**
**Old Orchard Road**
**Armonk, N.Y. 10504 (US)**

(72) Inventor: **Forster, Theodor**
**Oberdorfstrasse 33**
**CH-8800 Thalwil (CH)**
Inventor: **Kern, Dieter**
**2615 Colonial Street**
**Yorktown Heights, N.Y. 10598 (US)**
Inventor: **Vettiger, Peter**
**Langmoosstrasse 33**
**CH-8135 Langnau a. Albis (CH)**
Inventor: **Wilson, Alan Dixon**
**46 Chestnut Ridge Road**
**Armonk, N.Y. 10504 (US)**

(74) Representative: **Schröder, Otto H., Dr. Ing. et al**
**IBM Corporation Säumerstrasse 4**
**CH-8803 Rüschlikon (CH)**

Courier Press, Leamington Spa, England.

## Description

The invention relates to a proximity effect correction method for electron-beam lithography on substrates of varying material composition. The method is for use in systems where writing of pattern shapes, e.g., beam deflection and stepping, is under control of preprepared pattern data blocks, and in which signals indicative of the quantity of backscattered electrons are obtained during electron e-beam exposure.

Electron-beam (e-beam) direct writing has advanced to become a widely used technology for patterning high resolution structures. Minimum linewidths obtainable are in the submicron range ($<0.5$ μm) and depend among other parameters on beam diameter, accelerating voltage and resist system used. The versatility provided by computer controlled e-beam systems is also used to personalize chips on a wafer. The high degree of flexibility of e-beam exposure systems combined with the high resolution and overlay capabilities make this technology suitable for VLSI circuit patternings as well as for patterning masks for use in any projection lithography technique employed e.g. in optical, e-beam, X-ray, or ion-beam systems.

In e-beam systems, ordinarily, a layer of resist material, deposited on a substrate or over a previously formed structure, is exposed by an electron beam to form the desired pattern by subsequent resist developing, depositing or removing further material to obtain a structure of metal, semiconductor or insulator patterns having specific properties. The electron beam can be guided over the resist in a raster-scan or a vector-scan method to generate the desired pattern. Such e-beam lithography systems are described, e.g., in US Patents 3.644.700, 3.854.071, 3.866.013, 3.875.415, 3.876.883 and 4.056.730.

As minimum feature sizes are reduced, the so-called proximity effect due to electron scattering within the resist and from the substrate sets the limits for e-beam lithography. When electrons are scattered outside the shape being exposed, they do not contribute to the dose of this particular shape—this is referred to as the intra-shape proximity effect—whereas they may contribute to the dose received by neighbouring shapes—this causing the so-called inter-shape proximity effect. The total energy dissipated in the resist by a given dose of primary electrons depends very much on the number of backward-scattered electrons from the substrate into the resist. The number of backscattered electrons increases with increasing atomic number Z and thickness of the substrate material. The variations in effective dose caused by the scattered electrons lead to variations in linewidth and resist profile after development and pattern transfer.

Many articles have been published on the subject of proximity effect and approaches to correct it. These correction techniques correct for inter- and intra-shape proximity effects by assuming that the substrate material on which the pattern is being exposed has the same backscattering behaviour across the entire area. Dose and size compensations are calculated by simulating the scattering process and determining a corresponding dose or size for each shape/subshape of the design.

These proximity correction techniques essentially involve the following: In advance of the e-beam exposure process the pattern to be generated is analyzed using a computer program. It is then determined how an even dose distribution of electrons for a given shape or subshape can be achieved despite proximity effects. This operation is an integral part of the post-processing necessary to transform the pattern design data into an e-beam system data format. The obtained pattern data with appended values for exposure changes (a block of pattern data containing the e-beam writing control data for a specific shape of a complete pattern) are then stored and used to control the e-beam during the exposure or writing process in a different way than it would be controlled without correction.

Such method is described in an article "Proximity Effects in Electron Lithography: Magnitude and Correction Techniques" published in IBM J. Res. Develop., Vol 24, No. 4, July 1980, pp. 438—451.

In vector-scan type e-beam systems, this correction technique adjusts the exposure intensity of each shape/subshape by changing the e-beam stepping rate which is determined by the pattern data used.

Since the degree of backscattering into the resist is a function of the atomic number and thickness of the substrate, the beam accelerating voltage, and the resist thickness, the proximity corrected dose values are only valid if the backscattering is the same across the exposed area. This assumption is only correct, if the substrate consists of a single material or if the spread in the atomic numbers of the substrate materials is small. However, today's most promising semiconductor technologies, Si and GaAs, are more and more using substrate compositions with a large spread in atomic numbers. The influence on linewidth variations in direct e-beam writing due to substrate materials with different atomic numbers thus becomes a problem in high-resolution applications.

A new method, described in published European patent application 0 080 526, demonstrates the potential of using the backscattered signal for instantaneous feedback control of the beam stepping rate while the pattern is exposed. With this approach one is able to correct line-width variations due to different degrees of backscattering caused by variations of the substrate material for isolated shapes (intra-shape correction).

Although this substrate correction technique provides good results for isolated lines on different substrates it does not solve the problem of linewidths or gap variations due to shape-to-shape interaction (intershape effect).

More recently the substrate correction has been combined with the proximity correction (for a single base substrate) in order to correct for inter-shape proximity effects. This method has been described in an article "Proximity Effect Correction on Substrates of Variable Material Composition" (J. Vac. Sci. Technol. B1 (4), October-December 1983, p. 1378 ff.).

Such combined techniques are capable of correcting for inter- and intra-shape proximity effects on different substrates for linewidth and gaps of minimal 1 μm but they show fundamental limitations at smaller gap/line-width dimensions. This is mainly because the scattering distribution on a high atomic number material such as Pb is becoming very different from the distribution for a low atomic number material such as Si, the latter being used for the proximity correction calculations in the post-processor.

Another way to reduce or eliminate the proximity effects is the use of multilayer resist structures. This, however, at the expense of additional and more complicated process steps such as dry etching.

Since the demand for submicron VLSI patterning is increasing there is a strong interest for proximity effect correction on substrates of variable material composition for submicron e-beam lithography. It is, therefore, a main object of the present invention to provide a method that will be very close to the optimum proximity correction solution for any substrate composition even for submicron dimensions and that offers a number of unique features not available in present solutions. These can be summarized as follows:
—Limits for direct e-beam writing on substrates of variable material composition are extended into the submicron regime,
—it does not require multilayer resists which call for complicated processes,
—it requires only very modest changes in present post-processor and pattern data structures,
—only minor hardware changes for systems applying proximity correction through beam-stepping control are necessary,
—the pattern can be exposed on any substrate composition (even homogeneous substrates like Cr-masks) without additional postprocessing, and
—the proposed technique automatically selects the most suitable correction at each pixel to be exposed and operates in real time.

These objects are achieved by the invention as defined in claim 1 which solves the problems caused by the intra- and inter-shape proximity effects that have still not been satisfactorily reduced by hitherto known techniques particularly where submicron patterns are to be deposited on substrates of varying materials.

The main advantage offered by the invention is that a considerable reduction in linewidth and gap variations is achieved under "difficult" conditions, i.e., for submicron shapes and varying substrates, and with little additional processing and hardware requirements.

One way of carrying out the invention is described in detail below with reference to drawings which illustrate only one specific embodiment, in which:

Figure 1 illustrates the energy deposition distribution from backscattered electrons for different substrate materials.

Figure 2 shows an atomic number scale for various substrate materials and an indication as to how materials can be grouped for the execution of the present invention.

Figure 3 is a block diagram of an electron beam exposure system suited for the method of the present invention.

Even the most advanced technique hitherto described, i.e., that combining proximity and substrate correction, still has its drawbacks in that inter-shape corrections are calculated only for a single base substrate. Since interactions between neighbouring shapes and lines differ substantially depending on the substrate, linewidth and gap still vary in submicron applications.

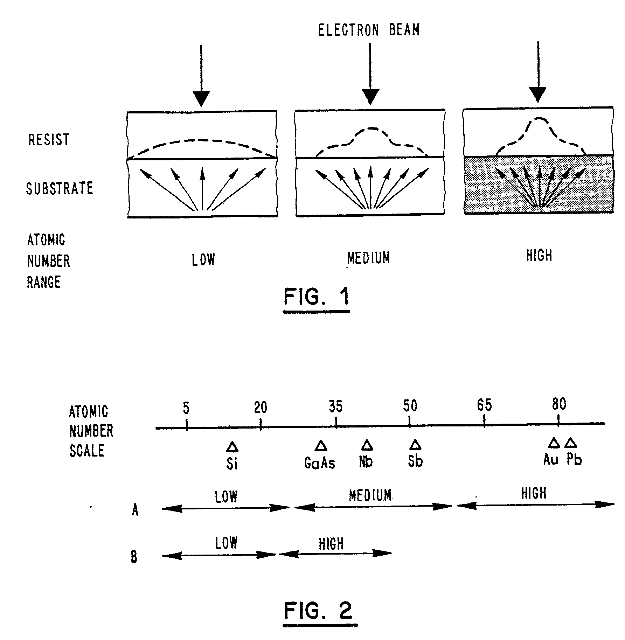

The effect of different substrate materials on the amount and particularly on the energy distribution in the photoresist by backscattered electrons is illustrated in Figure 1. For given e-beam acceleration and resist thickness, the backscattering is mainly determined by the atomic number Z of the substrate material. The three diagrams of Figure 1 show the energy distribution from backscattered electrons for different materials, their atomic number Z being in a low, medium, or high range, respectively. As shown, both, magnitude and shape of the distribution curves differ substantially and particularly the inter-shape proximity effect, i.e., the interaction with neighbouring shapes, will differ accordingly.

An effective proximity correction technique, therefore, calls for electron beam controlling pattern data that take the substrate material into consideration. If the material of the substrate, underlying the resist into which a pattern is to be written, varies, the controlling pattern data will have to vary as well, preferably in real time.

The inventive method described hereinafter provides for such process basically requiring three steps:
—Multiple (N) pattern data sets (in the hereinafter described embodiment of the invention referred to as $F_L$, $F_M$ and $F_H$) providing for proximity correction, each set for a different substrate material or group of materials (in the embodiments for 3 groups: L, M and H, i.e., N=3, need to be prepared (ideally one for each of all possible substrate materials),
—Real time determination of the substrate material during e-beam exposure, and
—Selection and use of the pattern data set corresponding to the determined substrate material.

In view of the substantial number of different substrate materials that may be used, this ideal but complex system has to be reduced to practicability. This is done by grouping substrate materials of similar degree and distribution of the backscattering, i.e., materials of similar atomic numbers, into N ranges, practical values for N being between 2 and 4.

Figure 2 shows an atomic number scale with some of the materials that will most likely be used in today's VLSI processes indicated. It also illustrates two examples (A, B) for possible ranges, with N being equal to 3 and 2, respectively. Example A would be employed if the range of substrate materials (and their atomic numbers) is wide-spread, e.g., from Si to Pb, whereas example B would be appropriate where different but similar (with regard to their backscattering properties) substrate materials are used.

This grouping of substrate materials results in a substantial reduction in the number of required pattern data sets from a potentially high number of different substrates to a low N, and thus in a reduction in required data processing and hardware. It makes the basic approach outlined above feasible and practicable, and virtually permits real time operation and correction.

Using available post-processor proximity correction programs, multiple pattern data sets are calculated, one for each of the N substrate ranges, the calculations taking into account the different material parameters of the materials of the N ranges. Each of the N pattern data sets (e.g. for N=3, corresponding respectively to a "low", a "medium" and a "high" Z-range) then comprises, for every shape/subshape data block, material-dependent beam-stepping rate information hereinafter referred to as $F_L$, $F_M$ or $F_H$. In the described embodiment, these F-signal sets determine the required adjustments of the base stepping rate of the e-beam system. F-signals could, however, also be used alone to determine the required stepping rate.

The required additional pattern data storage space is modest since N is small and, in fact, $(N-1)$ of the F-data are described as relative deviations from a base correction which may, e.g., correspond to the "low" atomic number range.

It is noted that additional postprocessing and pattern data storage space are only required for that part (F) of the pattern data that defines the necessary e-beam stepping rate adjustments. Other data contained in the pattern data string, such as those used to control the e-beam deflection ($X_o$, $Y_o$, $\Delta X$, $\Delta Y$), are independent of the substrate material and therefore need, for any given pattern, to be processed and stored only once.

Real time determination of the substrate material during e-beam exposure is also reduced to the determination of the range to which the material belongs. This can be done with sufficient accuracy by measuring the back-scattered electrons using the backscattering signal detector already provided in present e-beam systems. It is done while the pattern is written: At each pixel being exposed, the degree of backscattering is measured and the range, e.g., low, medium or high, determined.

Upon determination of the substrate material range, the corresponding beam stepping data set ($F_L$, $F_M$ or $F_H$) providing for proximity correction adjusted to the particular substrate material range is fetched from storage to control the beam stepping control circuitry accordingly. Tests have proven that the mechanism of backscatter measuring and stepping rate adjustment is fast enough for real time beam stepping control.

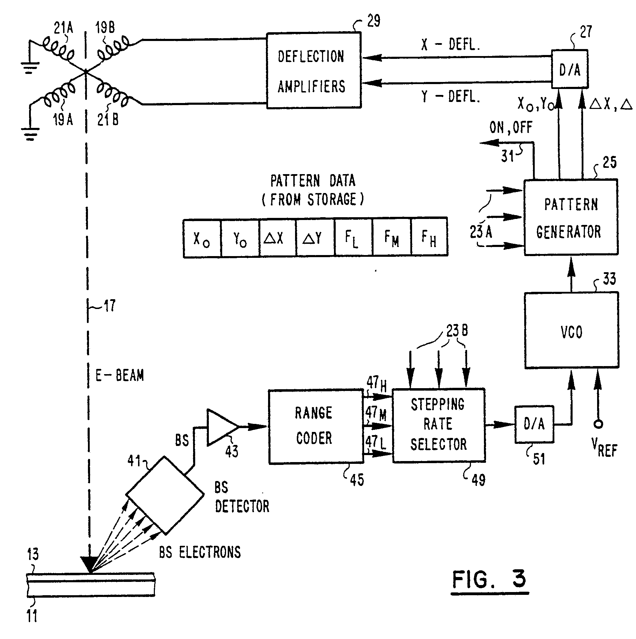

Figure 3 shows a block diagram of an e-beam vector scan lithography system in which the new correction technique can be implemented. Only those units are shown which are important for the present invention. More complete descriptions of e-beam lithographic systems are contained in the above mentioned patents.

A substrate 11 is covered by a photoresist layer 13 which is exposed by electron beam 17. e-beam 17 is deflected over the photoresist in a vector-scan mode by the magnetic fields of X deflection coils 19A, 19B and Y deflection coils 21A, 21B, and it is blanked and unblanked by control electrodes not shown in the drawing, for generating the desired shape.

Pattern data ($X_o$, $Y_o$, $\Delta X$, $\Delta Y$) describing the shape to be written are fed from a computer storage via input lines 23A to a pattern generator 25. The pattern generator furnishes for each of a number of elementary shapes, origin coordinates $X_o$ and $Y_o$, and further furnishes, successively and alternatingly, stepping values $\Delta X$ and $\Delta Y$ for moving the e-beam from the selected origin along a specific path. The digital X and Y signals are transferred to digital/analog converters 27 which provide at their outputs an X deflection signal and a Y deflection signal in analog form. These signals are amplified in deflection amplifiers 29 and then applied to e-beam deflection coils 19A, 19B and 21A, 21B.

A control signal for blanking and unblanking the e-beam while it moves from shape to shape, is also provided by pattern generator 25 on an output line 31. This signal is applied to blanking/unblanking electrodes not shown in the drawing.

The speed or stepping rate at which the electron beam moves is determined by the output signal of a voltage-controlled oscillator (VCO) 33. This output frequency or stepping rate signal is applied to an input of pattern generator 25 and determines the rate at which the beam is deflected within a shape. The basic stepping rate, i.e., the rate at which the beam would be moved in the absence of stepping rate corrections F included in the pattern data, is determined by reference voltage $V_{REF}$ applied to voltage controlled oscillator 33.

Without the correction technique of the invention, e-beam 17 would move across photoresist layer 13 at the basic stepping rate determined by reference voltage $V_{REF}$ and the resulting lines and patterns would be distorted by intra- and inter-shape proximity effects.

To compensate for the backscatter effects, the new technique is implemented as follows: Backscatter electrons are measured by BS detector 41 that produces an output signal BS proportional to the rate of backscattering. Signal BS is amplified in amplifier 43 and applied to N-level range coder circuit 45 which provides a level signal on one of lines $47_L$, $47_M$ or $47_N$ in accordance with the magnitude of the BS signal. The number of levels N, between which circuit 45 is able to distinguish, is chosen to correspond to the number of different proximity correction stepping rate control signal sets F (e.g., $F_L$, $F_M$, $F_H$) provided by the pattern data stored in memory. For many application, N=3 appears to be a proper choice.

The level signal is applied to stepping rate selector 49 where the stepping rate correction signal set F corresponding to the BS signal level is selected. Correction sequences F that are part of the pattern data sets stored in memory are fed to the stepping rate selector 49 via lines 23B.

The selected signal sequence F is then, after conversion to an ac voltage signal in D/A converter 51, applied to voltage controlled oscillator 33 where it adjusts the basic oscillator frequency and thus the beam stepping rate signal applied to pattern generator 25. The generator 25 then controls the e-beam deflection adjusted to eliminate the proximity effects.

In summary: The basic beam stepping rate is continuously influenced by stepping rate correction signal strings F that are part of N different pattern data sets, each preprepared for a given range of substrate materials. As soon as a measured backscattered signal indicates a change in substrate material, control immediately switches from the initial signal string to the string corresponding to the BS signal level now detected. From then onwards, e-beam writing is proximity corrected for the "second" substrate material until another change in the substrate is detected. The BS signal is only used to select the proper proximity correction control strings F (in the example $F_L$, $F_M$ or $F_H$). It is not used for any direct substrate correction as in previously described systems. The operation is real time in that BS signal changes are processed at such high speed that the circuit delays have only a negligible effect on the resulting pattern quality.

## Claims

1. Proximity effect correction method for electron-beam lithography on substrates of varying material composition for use in systems where electron-beam writing of pattern shapes is under control of preprepared pattern data blocks, each pattern data block containing the electron-beam writing control data for a specific shape of a complete pattern, and in which signals indicative of the quantity of backscattered electrons (BS) are obtained during electron-beam exposure, the quantity of backscattered electrons providing an indication of substrate composition, characterized in that
—each pattern data block comprises N sets ($F_L$, $F_M$, $F_H$) of beam stepping rate correction signals that are required for stepping rate adjustments that are required for different substrate composition ranges, N corresponding to the number of different electron backscattering intensity ranges (L, M, H) distinguishable by the system,
—the magnitude of the backscatter signal (BS) is used to determine the backscattering intensity range (L, M, H), and
—the correction signal set ($F_L$, $F_M$, $F_H$) that corresponds to the determined range is used to control the electron-beam stepping rate.

2. Method as claimed in claim 1, wherein the stepping rate correction signal sets ($F_L$, $F_M$, $F_H$) provide for correction of inter-shape proximity effects.

3. Method as claimed in claim 2, wherein the signals of the stepping rate correction signal sets ($F_L$, $F_M$, $F_H$) are applied to a voltage-controlled oscillator (33) to adjust the oscillator frequency which, in turn, determines the beam stepping rate.

4. Method as claimed in claim 1, wherein the beam stepping rate adjustment to varying substrate compositions is a real time operation in that it takes place during electron-beam writing, the delay caused by the electronic circuitry involved being such as to have only a negligible effect on the resulting pattern quality.

5. Method as claimed in claim 1, wherein the backscatter signal (BS) is fed to a multi-level coder circuit (45) which determines the backscatter signal level range and provides a level signal on that output line ($47_L$ $47_M$, $47_H$) associated with the determined range.

6. Method as claimed in claim 5, wherein the number of ranges between which the coder circuit (45) is able to distinguish is chosen to correspond to the number (N) of sets of stepping rate correction signals comprised in the pattern data blocks.

7. Method as claimed in claim 6, wherein the number of ranges is 3.

8. Method as claimed in claim 5, wherein the level signal provided on one of the coder circuit output lines ($47_L$, $47_M$, $47_H$) is applied to a stepping rate selector (49) where the stepping rate correction signal set ($F_L$, $F_M$, $F_H$) corresponding to the determined range of the backscatter signal (BS) is selected.

9. Method as claimed in claim 8, wherein the selected stepping rate correction signal set ($F_L$, $F_M$, $F_H$) is applied to a voltage controlled oscillator (33) to adjust the oscillator frequency and thus the beam stepping rate.

## Patentansprüche

1. Korrekturmethod des Nahwirkungseffekts in der Elektronenstrahllithographie für Substrate mit unterschiedlichen Materialzusammensetzungen zur Verwendung in Systemen, in denen das Schreiben von Mustern mittels eines Elektronenstrahls unter der Kontrolle von Musterdatenblöcken erfolgt, wobei jeder Musterdatenblock die Elektronenstrahl-Schreibkontrolldaten beinhaltet, die für ein komplettes Muster einer spezifischen Form benötigt werden, und in welchen Signale, die der Anzahl der rückgestreuten Elektronen (BS) entsprechen, während des Einwirkens des Elektronenstrahls gebildet werden, wobei die Anzahl der rückgestreuten Elektronen einen Hinweis auf die Substratzusammensetzung leifert, dadurch gekennzeichnet, dass

—jeder Musterdatenblock N Sätze ($F_L$, $F_M$, $F_H$) von Strahlschrittraten-Korrektursignalen für die Schrittratenregelung enthält, die für die unterschiedlichen Bereiche von Substrat-Zusammensetzungen erforderlich sind, wobei N der Anzahl der verschiedenen Elektronenrückstreuungsintensitätsbereiche (L, M, H) entspricht, die vom System unterschieden werden können,

—die Amplitude des Rückstreuungssignals (BS) dazu benützt wird, den Rückstreuungsintensitätsbereich (L, M, H) zu bestimmen, und

—der Satz von Korrektursignalen ($F_L$, $F_M$, $F_H$), der dem ermittelten Bereich entspricht, dazu benutzt wird, die Schrittrate des Elektronenstrahls zu steuern.

2. Methode nach Anspruch 1, bei welcher die Korrektursignalsätze ($F_L$, $F_M$, $F_H$) für die Schrittrate zur Korrektur von durch benachbarte Muster hervorgerufene Nahwirkungseffekte dienen.

3. Methode nach Anspruch 2, bei welcher die Signale der Schrittraten-Korrektursignalsätze ($F_L$, $F_M$, $F_H$) einem spannungsgesteuerten Oszillator (33) zugeführt werden, um die Oszillatorfrequenz anzupassen, die ihrerseits die Strahlschrittrate bestimmt.

4. Methode nach Anspruch 1, bei welcher die Anpassung der Strahlschrittrate an die unterschiedlichen Substratzusammensetzungen in einer Realzeit-Operation erfolgt, indem sie während der Elektronenstrahl-Schreibvorgang vorgenommen wird, wobei die durch die elektronischen Schaltungen hervorgerufene Verzögerung so gering ist, dass der Einfluss auf die Qualität des resultierenden Musters vernachlässigbar ist.

5. Methode nach Anspruch 1, bei welcher das Rückstreusignal (BS) einer mehrstufigen Kodierschaltung (45) zugeführt wird, die den Rückstreuungssignal-Niveaubereich bestimmt und ein Bereichssignal auf der Ausgangsleitung ($47_L$, $47_M$, $47_H$) abgibt, die dem ermittelten Bereich zugeordnet ist.

6. Methode nach Anspruch 5, bei welcher die Anzahl der Niveaubereiche, die die Kodierschaltung (45) zu unterscheiden vermag, derart gewählt ist, dass sie der Anzahl (N) von Sätzen von Schrittraten-Korrektursignalen entspricht, die in den Musterdatenblöcken enthalten sind.

7. Methode nach Anspruch 6, bei welcher die Anzahl der Bereiche gleich 3 ist.

8. Methode nach Anspruch 5, bei welcher das Niveaubereichsignal, das auf einer der Ausgangsleitungen ($47_L$, $47_M$, $47_H$) der Kodierschaltung erscheint, einer Schrittratenwählschaltung (49) zugeführt wird, in der ein Schrittraten-Korrektursignalsatz ($F_L$, $F_M$, $F_H$) gewählt wird, der dem ermittelten Bereich des Rückstreusignals (BS) entspricht.

9. Methode nach Anspruch 8, bei welcher der gewählte Schrittraten-Korrektursignalsatz ($F_L$, $F_M$, $F_H$) einem spannungsgesteuerten Oszillator (33) zugeführt wird, um die Oszillatorfrequenz und damit die Strahlschrittrate anzupassen.

## Revendications

1. Procédé de correction des effets de proximité en lithographie par faisceau d'électrons, sur des substrats de diverses compositions de matières, pour être utilisé dans des systèmes dans lesquels l'écriture par faisceau d'électrons des formes de modèles est commandée par des blocs de données préparés d'avance, chaque bloc de données du modèle contenant les données de commande d'écriture par faisceau d'électrons pour une forme spécifique d'un modèle complet, et dans lequel des signaux indicatifs de la quantité d'électrons rétrodiffusés (BS) sont obtenus au cours de l'exposition du faisceau d'électrons, la quantité d'électrons rétrodiffusés fournissant une indication de la composition du substrat, caractérisé par le fait que:

—chaque bloc de données de modèle comprend N jeux ($F_L$, $F_M$, $F_H$) de signaux de correction de la vitesse pas à pas du faisceau pour les ajustements de vitesse pas à pas qui sont nécessaires pour différentes gammes de composition du substrat, N correspondant au nombre des différentes gammes d'intensité de rétrodiffusion d'électrons (L, M, H) pouvant être distinguées par le système,

—l'amplitude du signal de rétrodiffusion (BS) est utilisée pour déterminer la gamme d'intensité de rétrodiffusion (L, M, H), et

—le jeu de signaux de correction ($F_L$, $F_M$, $F_H$) qui correspond à la gamme déterminée sert à commander la vitesse d'avance pas à pas du faisceau d'électrons.

2. Procédé conforme à la revendication 1, dans lequel les jeux de signaux de correction ($F_L$, $F_M$, $F_H$) de la vitesse d'avance pas à pas assure la correction des effets de proximité inter-formes.

3. Procédé selon la revendication 2, dans lequel les signaux des jeux de signaux ($F_L$, $F_M$, $F_H$) de correction de la vitesse pas à pas sont appliqués à un oscillateur (33) commandé par tension pour régler la fréquence de l'oscillateur qui, à son tour, détermine la vitesse pas à pas du faisceau.

4. Procédé conforme à la revendication 1, dans lequel le réglage de la vitesse pas à pas du faisceau pour faire varier les compositions de substrat est une opération en temps réel par le fait qu'il a lieu pendant l'écriture par faisceau d'électrons, le retard causé par le circuit électronique impliqué étant tel qu'il n'y a qu'un effet négligeable sur la qualité des modèles résultants.

5. Procédé selon la revendication 1, dans lequel le signal de rétrodiffusion (BS) est amené à un circuit codeur (45) à niveaux multiples qui détermine la gamme de niveau du signal de rétrodiffusion et fournit un signal de niveau sur cette ligne de sortie ($47_L$, $47_M$, $47_H$) qui est associée à la gamme déterminée.

6. Procédé selon la revendication 5, dans lequel le nombre de gammes entre lesquelles le circuit codeur (45) est capable de distinguer est choisi de façon à correspondre au nombre (N) de jeux de signaux de correction de la vitesse d'avance pas à pas compris dans les blocs de données du modèle.

7. Procédé selon la revendication 6, dans lequel le nombre de gammes est de 3.

8. Procédé conforme à la revendication 5, dans lequel le signal de niveau fourni sur l'une des lignes de sortie du circuit codeur ($47_L$, $47_M$, $47_H$) est appliqué à un sélecteur de vitesse pas à pas (49) où le jeu de signaux de correction ($F_L$, $F_M$, $F_H$) de la vitesse pas à pas correspondant à la gamme déterminée du signal de rétrodiffusion (BS) est sélectionné.

9. Procédé conforme à la revendication 8, dans lequel le jeu de signaux de correction ($F_L$, $F_M$, $F_H$) de la vitesse pas à pas sélectionné est appliqué à un oscillateur commandé par tension (33) pour régler la fréquence de l'oscillateur et, en conséquence, la vitesse d'avance pas à pas du faisceau.

**EP 0 166 004 B1**

ELECTRON BEAM

RESIST

SUBSTRATE

ATOMIC NUMBER RANGE

LOW  MEDIUM  HIGH

FIG. 1

FIG. 2

1

PATTERN DATA
( FROM STORAGE )

| $X_0$ | $Y_0$ | $\triangle X$ | $\triangle Y$ | $F_L$ | $F_M$ | $F_H$ |
|---|---|---|---|---|---|---|

FIG. 3